# EUROPEAN PATENT SPECIFICATION

(11) **EP 2 899 883 B1**
(45) Date of publication and mention of the grant of the patent: **20.07.2016**
(21) Application number: 15152561.5
(22) Date of filing: 26.01.2015
(51) Int. Cl.: H03G 9/00, H03G 9/02

(54) **Sound producing system and audio amplifying method thereof**
Tonerzeugungssystem und Tonverstärkungsverfahren dafür
Système de production de son et son procédé d'amplification audio

(30) Priority: 28.01.2014 US 201461932261 P; 21.07.2014 US 201414335954
(43) Date of publication of application: 29.07.2015
(73) Proprietor: HTC Corporation, Taoyuan City 330 (TW)
(72) Inventor: Cheng, Chih-Chiang, Taoyuan District, Taoyuan City 330 (TW); Lee, Chun-Min, Taoyuan District, Taoyuan City 330 (TW); Tong, Hann-Shi, Taoyuan District, Taoyuan City 330 (TW)
(74) Representative: Emde, Eric

(56) References cited:
- EP-A1- 2 369 852
- WO-A1-2011/115944
- WO-A2-01/03466
- US-A1- 2013 077 795
- US-A1- 2013 195 277
- US-A1- 2013 259 245

## Description

### BACKGROUND

### Field of the Invention

The invention relates to a sound producing system and a method thereof. Particularly, the invention relates to the sound producing system with multi-band dynamic range control operation.

### Description of Related Art

In conventional sound producing system, a gain of the amplifying apparatus is automatic controlled according to the excursion of the speaker. In the opinion of the audio and the excursion, a content of the audio includes a first resonance frequency audio from the speaker. A loudness of the first resonance frequency audio is limited by an excursion of the diaphragm of the speaker and the sense of hearing of human. Such as that, in digital space, a range of the gain for amplifying the audio is limited, and the improvement space for low frequency band of the audio is limited, too.

US 2013/259245 A1 discloses a control method of sound producing, a sound producing apparatus, and a portable apparatus. The control method of sound producing is for a portable device, including the following steps. (a) A first detected parameter indicating a detected excursion of a speaker of the portable device is generated. (b) A second audio signal is generated based on a first audio signal, wherein the second audio signal is generated selectively by compensation according to at least the first detected parameter. (c) A gain value is determined according to at least the first detected parameter and a third audio signal is generated based on the second audio signal according to the gain value.

WO2011/115944 A1 discloses a distortion reducing multi-band compressor with timbre preservation. Timbre preservation is achieved by determining a time-varying threshold in each of a plurality frequency bands as a function of a respective fixed threshold for the frequency band and, at least in part, an audio signal level and a fixed threshold outside such frequency band. If a particular frequency band receives significant gain reduction due to being above or approaching its fixed threshold, then a time-varying threshold of one or more other frequency bands are also decreased to receive some gain reduction. In a specific embodiment, time-varying thresholds can be computed from an average difference of the audio input signal in each frequency band and its respective fixed threshold.

WO 01/03466 A2 discloses a loudspeaker protection system which comprises filter means for defining one or more frequency bands of an audio signal, controllable amplifier/attenuator means coupled to the filter means, and processing means coupled to control the amplifier/attenuator means, such as to determine audio power in at least one of said frequency bands representing relevant loudspeaker. protection information used for selective audio power control in said at least one frequency band. This system has the features for a fast and/or slow thermal protection, as well as for a cone excursion protection all for a loudspeaker in such a system.

US 2013/195277 A1 discloses a system for controlling distortion comprising a total harmonic distortion (THD) modeling system configured to apply a chirp signal to a system and to identify one or more frequency bands at which distortion is present, and to apply a ramping signal to identify for each of the one or more frequency bands an input signal level at which distortion is initiated, a signal processing system configured to receive an input signal, to determine whether frequency components are present in the input signal that are associated with the one or more frequency bands at which distortion is present, and to limit the amplitude of the input signal at the one or more frequency bands, such as by applying dynamic range compensation.

### SUMMARY OF THE INVENTION

The invention is directed to sound producing systems and method thereof, and the sound quality and loudness, especially in audible bass bands are optimized accordingly.

The invention provides a sound producing system as set forth in claim 1.

The invention also provides a sound producing method as set forth in claim 6.

Preferred embodiments of the present invention may be gathered from the dependent claims.

According to the above descriptions, in the invention, the estimated excursion of the speaker is obtained by the feedback current and the feedback voltage. The amplify gain is determined according to the estimated excursion of the speaker (as well as the signal controller). Furthermore, the MBDRAC operation is provided in the sound producing system and the sound producing system. That is, the input audio signal can be controlled by different frequency bands of the input audio, and the sound quality and loudness based on the speaker's (such as micro-speaker) ability can be improved.

In order to make the aforementioned and other features and advantages of the invention comprehensible, several exemplary embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A illustrates a sound producing system according to an exemplary embodiment of the present application.
FIG. 1B illustrates a block diagram of another sound producing system 102 according to an exemplary embodiment of the present invention.
FIG. 2 illustrates a block diagram of another sound producing system 200 according to another exemplary embodiment of the present invention.
FIG. 3 illustrates a diagram of input and output of the MBDRC 230 in FIG. 2.
FIG. 4 illustrates a block diagram of MBDRC 230 according to the exemplary embodiment of FIG. 2.
FIG. 5 illustrates a vibrating characteristic of the speaker according to an exemplary embodiment of the present invention.
FIG. 6A illustrates a control apparatus for a speaker system.
FIG. 6B illustrates a sound producing system 602 according to another embodiment of present application.
FIG. 7 illustrates a flow chart for a sound producing method according to an exemplary embodiment of the present invention.

### DETAILED DESCRIPTION OF DISCLOSED EMBODIMENTS

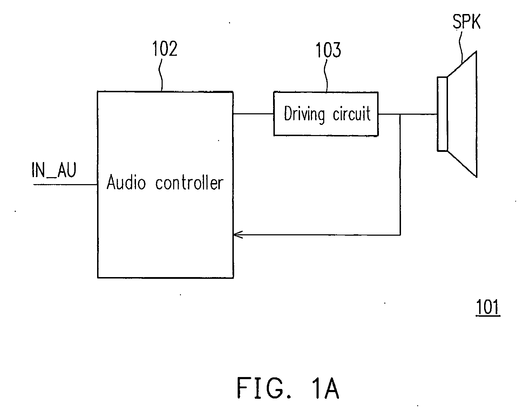

Referring to FIG. 1A, FIG. 1A illustrates a sound producing system according to an exemplary embodiment of the present application. The sound producing system 101 includes an audio controller 102, a driving circuit 103 and a speaker SPK. The speaker SPK is used for producing an audible sound. The driving circuit 103 is coupled to the speaker SPK and provides a signal for driving the speaker SPK. The audio controller 102 is coupled to the speaker SPK and the driving circuit 103. The audio controller 102 is configured to receive and process an input audio signal IN_AU, and generate and convert an output audio signal to a driving voltage. The driving circuit 103 provides the driving voltage to the speaker SPK for driving the speaker SPK.

In detail, the audio controller 102 receive an amplify gain and pre-amply the input audio signal IN_AU with the amplify gain to obtain a pre-amplified audio signal. Then, the audio controller 102 operates a multiband dynamic range control operation on the pre-amplified audio signal for generating the output audio signal. Furthermore, the audio controller 102 may convert the output audio signal to the driving voltage, and the driving voltage may be transported to the speaker SPK through the driving circuit 103 for driving the speaker SPK.

On the other hand, the audio controller 102 detects over the driving circuit 103 to obtain at least one excursion parameter of the speaker SPK. The audio controller 102 may determine an estimated excursion of the speaker SPK according to the at least one excursion parameter in response to the driving voltage. Also, the audio controller 102 adjusts the amplify gain according to the estimated excursion.

Please note here, the audio controller 102 may operate the multiband dynamic range control on the pre-amplified audio signal for generating a compressed audio signal. Then, the audio controller 102 may limit an overall level of the compressed audio signal to a threshold level by applying a limiting gain to the compressed audio signal for limiting the level of the output audio signal and obtaining a limited audio signal as the output audio signal. The limiting gain may also be adjusted according to the estimated excursion of the speaker SPK by the audio controller 102.

The speaker SPK has at least one diaphragm. The diaphragm has a highest response over a resonance frequency. In response thereto, the audio controller 102 is operative to operate a first dynamic range control operation over a first frequency band of the pre-amplified audio signal, and the first frequency band is below the resonant frequency. Moreover, the audio controller 102 is operative to operate a second dynamic range control operation over a second frequency band of the pre-amplified audio signal, and the second band is higher than the resonant frequency. Especially, the compression ratio of the first dynamic range control operation is higher than the compression ratio of the second dynamic range control operation.

The audio controller 102 is also operative to buffer the pre-amplified audio signal, and filter the buffered pre-amplified audio signal over at least two frequency bands to obtain at least two filtered audio signals each corresponding to one of the at least two frequency bands. The audio controller 102 operates at least two separated dynamic range controls over the at least two filtered audio signal respectively to obtain at least two compressed filtered audio signals. Additionally, the audio controller 102 obtains the compressed audio signals by summing the at least two compressed filtered audio signals.

About the estimated excursion, the audio controller 102 receives a driving current on the driving circuit 103, and generates a first excursion parameter accordingly. Wherein, the driving current is generated in response to the driving voltage applied on the speaker SPK, and the driving current is feedback to the audio controller 102 from the speaker SPK. On the other hand, the output audio signal generated by the audio controller 102 may be used to generate a second excursion parameter. That is, the audio controller 102 may determine the estimated excursion of the speaker SPK in response to the driving voltage based on the first excursion parameter and the second excursion parameter.

In the operation, the input audio signal IN_AU is transported to the audio controller 102 in continuity. The audio controller 102 may delay the input audio signal IN_AU to obtain a first input audio signal for looking ahead. Based on the first input audio signal, an estimated excursion of the speaker SPK in response to the first input audio signal can be determined by the audio controller 102, and whether the first estimated excursion enters a non-linear region of a force factor or stiffness for the speaker SPK can be determined accordingly. When the estimated excursion enters the non-linear region, the audio controller 102 may compensate the first input audio signal to generate a second input audio signal, and the audio controller 102 may pre-amplify the second input audio signal with the amplify gain to obtain the pre-amplified audio signal. Besides, based on the estimated excursion of the speaker SPK in response to the first input audio signal, whether the excursion of the speaker SPK exceeds a maximum allowable value can be determined accordingly. When the estimated excursion of the speaker SPK exceeds an excursion threshold, wherein the excursion threshold is corresponding to the value of the estimated excursion when the audio controller 102 may assume the excursion of the speaker SPK has exceeded the maximum allowable excursion, the audio controller 102 may reduce the amplify gain, and the excursion of the speaker SPK can be controlled to prevent from exceeding the maximum allowable value and to prevent the damage of the speaker SPK,. The excursion threshold may be predetermined according to the physical characteristics of the speaker. The excursion threshold can also be a predetermined threshold which the audio controller 102 may hard clip or soft clip the output audio signal to prevent the speaker SPK from damage.

About the driving circuit 103, a digital to analog converter and an amplifier may be disposed in the driving circuit 103. The digital to analog converter is used to convert the output audio signal to an analog output signal, and the amplifier is used to amplify the analog output audio signal under a bias voltage to obtain the driving voltage. The bias voltage may be controlled from the audio controller 102, and the audio controller 102 may detect a signal level of the first input audio signal over a time span, and adjust a level of the bias voltage based on the signal level of the first input audio signal. That is, the signal level of the first input audio signal may be monitored, and when the first input audio signal with small volume is inputted to the audio controller 102, the voltage level of the bias voltage for the amplifier can be reduced, and power consumption can be saved.

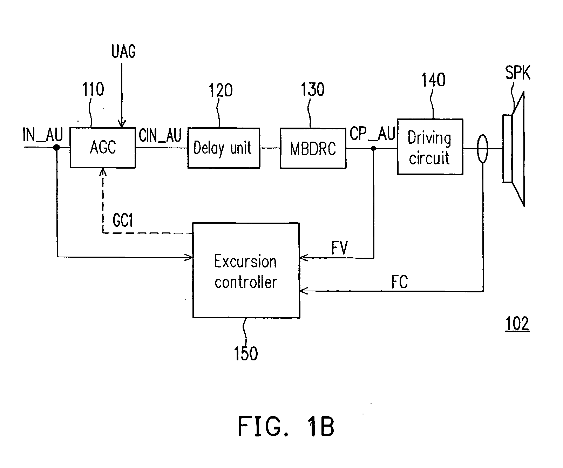

Referring to FIG. 1B, FIG. 1B illustrates a block diagram of another sound producing system 102 according to an exemplary embodiment of the present invention. The sound producing system 102 includes an automatic gain controller (AGC) 110, a delay unit 120, a multi-band dynamic range controller (MBDRC) 130, a limiter (not shown), a driving circuit 140 and an excursion controller 150. The sound producing system 100 is used to drive a speaker SPK.

The AGC 110 receives an input audio signal IN_AU and an amplify gain UAG, wherein the amplify gain UAG is provided by an application processor according to the setting of a playback application or instruction from an user, and the AGC 110 controls a gain of the input audio signal IN_AU to generate a pre-amplified audio signal CIN_AU according to the amplify gain UAG. The delay unit 120 is coupled between an output of the AGC 110 and an input of the MBDRC 130. The delay unit 120 provides a delay time for transporting the pre-amplified audio signal CIN_AU to the input of the MBDRC 130. The MBDRC 130 is coupled to the delay unit 120 for receiving the pre-amplified audio signal CIN_AU from the delay unit 120, and the MBDRC 130 operates a multi-band dynamic range control operation on the pre-amplified audio signal CIN_AU to generate an output audio CP_AU. A gain limiter may be used to limit the level of the output audio CP_AU. In FIG. 1B, the output audio CP_AU is transported to the amplifier 140, and the amplifier 140 amplifying the output audio CP_AU to drive the speaker SPK.

On the other hand, the excursion controller 150 is coupled between the driving circuit 140 and the AGC 110 to form a feedback circuit. The excursion controller 150 receives a voltage signal received by the amplifier 140 to formed a feedback voltage FV, and the excursion controller 150 also receives a current flowing through the speaker SPK to form a feedback current FC. The excursion controller 150 generates a first gain control signal GC1 according to the input audio signal IN_AU, the feedback voltage FV and the feedback current FC, and provided the first gain control signal GC1 to the AGC 110 to notify the ACG 110 whether an estimated excursion of the speaker SPK enters a non-linear region of a force factor or stiffness for the speaker. Accordingly, the audio controller 102 may compensate the first input audio signal to generate a second input audio signal when the ACG 110 receives the first gain control signal GC1 notifying that the estimated excursion of the speaker SPK enters the non-linear region.

In detail, the MBDRC 130 divides the pre-amplified audio signal CIN_AU into a plurality of parts according to a plurality of different frequency bands. The MBDRC 130 respectively operates a plurality of controlling (compressing or expanding) operations on the plurality of parts of the pre-amplified audio signal CIN_AU. The controlling operations respectively corresponding to the frequency bands may be different. That is, the different frequency bands of the pre-amplified audio signal CIN_AU can be respectively compressed or expanded by different methods, an optimized audio signal can be obtained.

It should be noted here, the estimated excursion of the speaker SPK is important in the embodiment. The excursion controller 150 calculates the estimated excursion of the speaker SPK according to the feedback voltage FV and the feedback current FC, and the excursion controller 150 generate the first gain control signal GC1 to notify the AGC 110 according to the estimated excursion and the input audio signal. For example, the excursion controller 150 calculates the estimated excursion of the speaker SPK according to the feedback voltage FV and the feedback current FC. For example, the excursion controller 150 calculates the estimated excursion of the speaker SPK by the impedance which is calculated by the feedback voltage FV and the feedback current FC, and obtains the first gain control signal GC1 according to the estimated excursion.

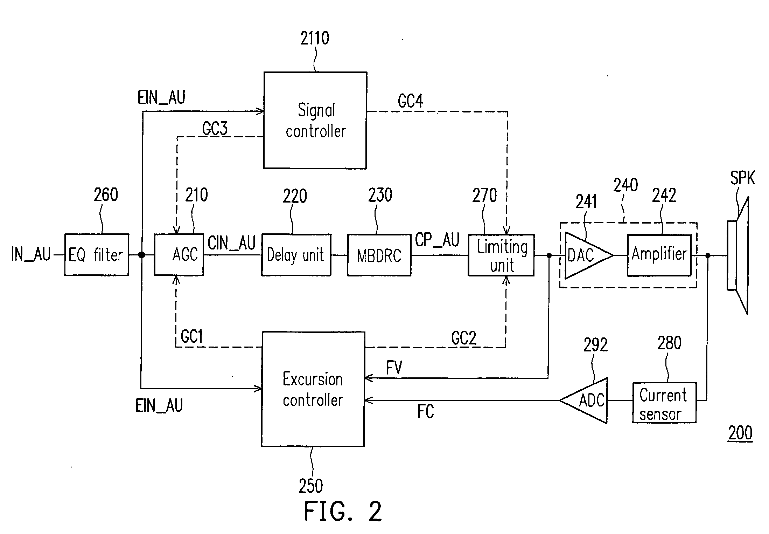

Referring to FIG. 2, FIG. 2 illustrates a block diagram of a sound producing system 200 according to another exemplary embodiment of the present invention. The sound producing system 200 includes an automatic gain controller (AGC) 210, a delay unit 220, a multi-band dynamic range controller (MBDRC) 230, an amplifier 242, an excursion controller 250, an equalization (EQ) filter 260, a limiting unit 270, a current sensor 280, a digital to analog converter (DAC) 241, an analog to digital converter (ADC) 292, and a signal controller 2110, wherein, the DAC 241 and the amplifier 242 form a driving circuit 240.

In FIG. 2, an input audio signal of music content may be preliminarily processed by the EQ filter 260, and the equalized input audio signal EIN_AU is sent to the AGC 210 for pre-amplifying by the AGC 210 according to an amplify gain. The AGC 210 generates the pre-amplified audio signal CIN_AU by amplifying the equalized input audio signal EIN_AU. Moreover, the pre-amplified audio signal CIN_AU is transported to the delay unit 220 and the delay unit 220 provides a delay time for transporting the pre-amplified audio signal CIN_AU to the MBDRC 230. During a period of the delay time, the excursion controller 250 is used to calculate the estimated excursion of the diaphragm of the speaker SPK, and the first gain control signal GC1 is generated by the excursion controller 250 according to the estimated excursion.

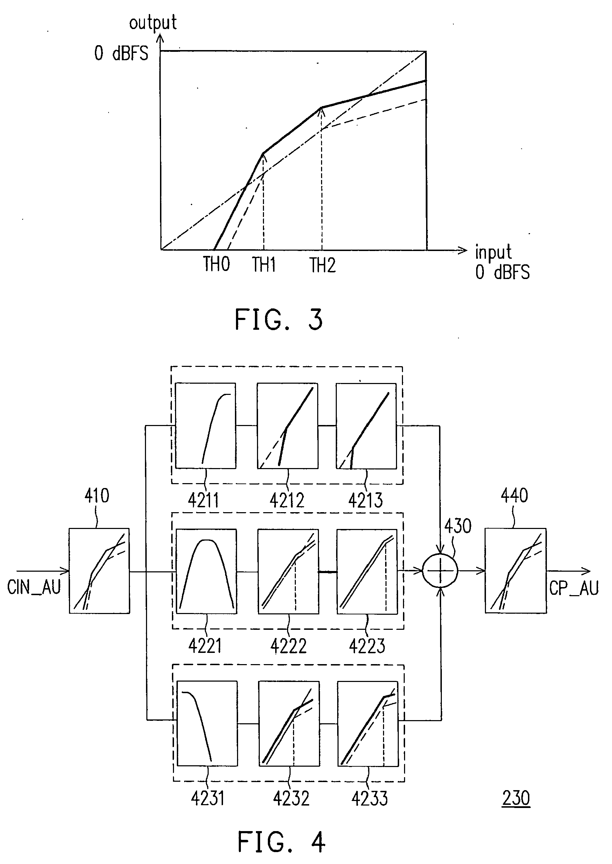

The pre-amplified audio signal CIN_AU is transported to the MBDRC 230 through the delay unit 220. Referring to FIG. 3, FIG. 3 illustrates a diagram of input and output of the MBDRC 230 in FIG. 2. In FIG. 3, the pre-amplified audio signal CIN_AU may be divided into three parts with different volumes. The MBDRC 230 may be an expander to process the input audio which volume is lower than TH1. In a middle volume region, the volume of the output audio may be matched up with the input audio when the volume of the input audio is between TH1 and TH2. In an upper volume region, the volume of the output audio is generated by reducing the volume of the input audio which is larger than TH2.

In detail, referring to FIG. 4, FIG. 4 illustrates a block diagram of MBDRC 230 according to the exemplary embodiment of FIG. 2. The MBDRC 230 includes a pre-dynamic range controller 410, band divided filters 4211, 4221 and 4231, dynamic range controllers 4212, 4213, 4222, 4223, 4232 and 4233, a summation unit 430, and a post-dynamic range controller 440. In FIG. 4, the pre-amplified audio signal CIN_AU is processed by the pre-dynamic range controller 410 in first stage, and then the output of the pre-dynamic range controller 410 is transported to the filters 4211, 4221 and 4231 for processing in parallel. The filters 4211, 4221 and 4231 are respectively a low pass filter, a band pass filter and a high pass filter. That is, the passing bands of the filters 4211, 4221 and 4231 respectively are different.

The filter 4231 filtered out the low frequency part of the pre-amplified audio signal CIN_AU, and the low frequency part of the pre-amplified audio signal CIN_AU is transported to the dynamic range controllers 4232 and 4233 in sequence for controlling. The filter 4221 filtered out the middle frequency part of the pre-amplified audio signal CIN_AU, and the middle frequency part of the pre-amplified audio signal CIN_AU is transported to the dynamic range controllers 4222 and 4223 in sequence for controlling. Further, the filter 4211 filtered out the high frequency part of the pre-amplified audio signal CIN_AU, and the high frequency part of the pre-amplified audio signal CIN_AU is transported to the dynamic range controllers 4212 and 4213 in sequence for controlling.

All of the outputs of the dynamic range controllers 4213, 4223 and 4233 are transported to the summation unit 430 for a summing operation. A result of the summing operation is transported to the post-dynamic range controllers 440 for controlling to generate the output audio CP_AU.

In this control process, it dynamically alters the compression or expansion ratio and corresponding make-up gain based on the characteristic of each band. By using this apparatus, it enhances and emphasizes the detail of the music content. In addition, the sound quality can be further improved by using expanders to depress the small hiss noise in high band, which is perceptually awful.

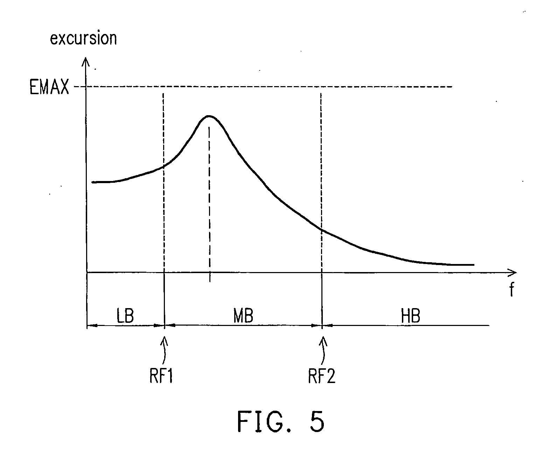

Referring to FIG. 5, FIG. 5 illustrates a vibrating characteristic of the speaker according to an exemplary embodiment of the present invention. The vibrating characteristic of a speaker may be divided according to the frequency bands of the input audio. In FIG. 5, the low band LB whose frequency is lower than the 1st resonant frequency RF1 of the speaker SPK; a mid-band MB whose frequency is above the 1st resonant frequency RF1 but below a second frequency RF2 (7kHz for example); and high band HB whose frequency is above the second frequency RF2. In low band LB, the excursion of the speaker SPK is inherently high so that an aggressive compression ratio is applied. Such as that, the excursion of the speaker SPK is limited to be lower than a maximum possible excursion EMAX of the speaker SPK. As for the mid-band MB, a low compression ratio is applied because the excursion of the speaker SPK has large headroom. For the high band HB, an expander is used to depress the small signal. The quality perceptually of the audio form the speaker SPK can be optimized.

Furthermore, in this apparatus, MDRC 230 is designed for each one of a plurality of bands. For middle volume, it is processed by applying a related slow attack time and release time to avoid pumping effect. As for the large volume, it is processed by applying a fast attack time and release time to depress an instant peak of a signal.

Referring to FIG. 2, the current sensor 280 is coupled between the speaker SPK and the excursion controller 250. The current sensor 280 senses a current flowing through the speaker SPK to generate the feedback current FC and transports the feedback current FC to the excursion controller 250. The ADC 292 is coupled to the current sensor 280, and the ADC 292 transport the feedback current FC from analog format to digital format. The excursion controller 250 receives the feedback current FC in digital format.

The limiting unit 270 is coupled to output of the MBDRC 230, and used for limiting a gain of the output audio CP_AU according to a second gain control signal GC2. Wherein, the second gain control signal GC2 is generated by the excursion controller 250. When the estimated excursion of the speaker SPK exceeds the excursion threshold, the excursion controller 250 can generate and transmit the second gain control signal GC2 to the limiting unit 270, so that the audio controller 200 can reduce the amplify gain once the limiting unit 270 receive the second gain control signal GC2.

The DAC 291 is coupled between the limiting unit 270 and the amplifier 240. The DAC 291 is used to convert the output of the limiting unit 270 from digital format to analog format.

The signal controller 2110 is coupled to the AGC 210, EQ filter 260 and the limiting unit 270. The signal controller 2110 receives the equalized input audio EIN_AU and provides a third gain control signal GC3 to the AGC 210 and a fourth gain control signal GC4 to the limiting unit 270. When the signal controller 2110 decides the estimated excursion to enter the non-linear region by analyzing the equalized input audio EIN_AU through a look ahead analyzing scheme, the signal controller 2110 transports the third gain control signal GC3 to the AGC 210. The AGC 210 may compensate the equalized input audio EIN_AU according to the third gain control signal GC3. On the other hand, when the signal controller 2110 decides the estimated excursion to enter an excursion threshold region by analyzing the equalized input audio EIN_AU through the look ahead analyzing scheme, the signal controller 2110 transports the fourth gain control signal GC4 to the limiting unit 270. The limiting unit 270 may limit a gain of the output audio CP_AU according to the fourth gain control signal GC4. In FIG. 2, the AGC 210 may receive the first and third gain control signals GC1 and GC3 for the gain controlling operation simultaneously, and the limiting unit 270 may receive the second and fourth gain control signals GC2 and GC4 for the gain limiting operation simultaneously.

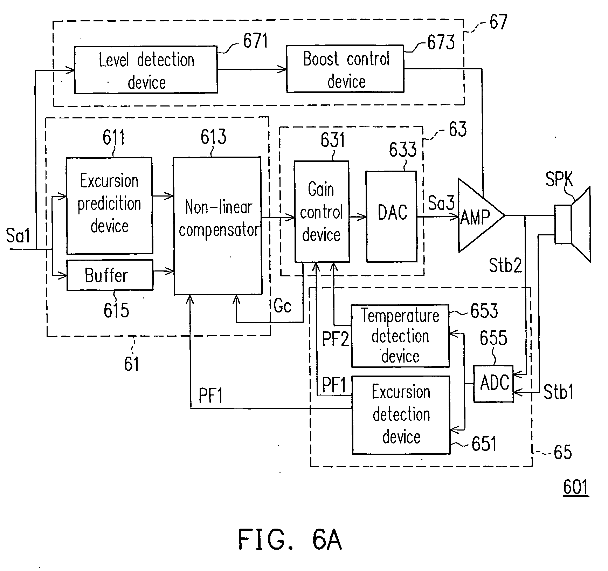

Referring to FIG. 6A, FIG. 6A illustrates a control apparatus for a speaker system. The structure for a control apparatus 601 as shown in FIG. 6A includes a compensation unit 61, a gain unit 63, and a feedback unit 65. In FIG. 6A, an input audio signal (or called a first audio signal) Sa1 is to be amplified by an amplifier AMP and then to be reproduced by the speaker SPK.

In FIG. 6A, the compensation unit 61 includes an excursion prediction device 611 for excursion calculation, a non-linear compensator 613, and a buffer 615. In an example, the compensation unit 61 performs look-ahead based compensation. The first audio signal Sa1, e.g., in the form of a digital signal, is looked ahead, for example, by using the buffer 615. In practical application, the first audio signal Sa1 may need to be conditioned or can be default as a conditioned signal, or a signal conditioning circuit stage can be optionally included in the control apparatus 601 for generating the conditioned signal for processing of the following stages. For the sake of explanation, the first audio signal Sa1 can be regarded as a conditioned signal in the embodiment. The excursion prediction device 611 predicts or evaluates the corresponding excursion of the first audio signal Sa1 through a first model for the speaker SPK to generate a predicted excursion of the first audio signal. The non-linear compensator 613 determines whether compensation is needed according to the delayed first audio signal from the buffer 615 and the predicted excursion outputted from the excursion prediction device 611. In addition, the non-linear compensator 613 generates a second audio signal Sa2 by compensation according to the first model and the first detected parameter (denoted by PF1), the value Gc from the gain control unit 63, and the delayed first audio signal Sa1. If compensation for the first audio signal Sa1 is not needed, the non-linear compensator 613 outputs the first audio signal as the second audio signal Sa2 (or may be outputted through a scaling).

In determination as to whether compensation is needed, the non-linear compensator 613 may adopt one or more physical parameters of the speaker SPK so as to determine whether the predicted first parameter (such as excursion) enters a non-linear region of the physical parameter.

The gain unit 63 includes a gain control device 631 and a digital-to-analog converter (DAC) 633. In response to the second audio signal Sa2 and at least one detected parameter (such as the first detected parameter PF1 and/or second detected parameter PF2 and so on), the gain control device 631 outputs an output audio signal. In one example, the output audio signal may be converted by the DAC 633 so as to output a third audio signal Sa3 for the amplifier AMP. In addition, the gain control device 631 outputs a parameter, such as a value Gc indicating the gain value currently used in the gain unit 63, to the non-linear compensator 613 in order for the non-linear compensator 613 to adjust the non-linear compensation according to the current gain value.

The feedback unit 65 is employed to generate at least one detected parameter according to a feedback signal Sfb indicating such as a feedback current signal Sfb1 and a feedback voltage signal Sfb2 from the speaker SPK. The feedback unit 65 includes an excursion control device (or called an excursion detection device) 651, a temperature detection device (or called a temperature detection device) 653, and an analog-to-digital converter (ADC) 655. The feedback current Sfb1 and the feedback voltage Sfb2 are evaluated through the temperature detection device 651 and the excursion detection device 651, respectively, so as to generate a first detected parameter PF1 (e.g., the detected excursion of the speaker) and a second detected parameter PF2 (e.g., the temperature of the speaker). According to one or more detected parameters such as PF1 and PF2 and the second audio signal Sa2, the gain control device 631 adjusts its gain value. The first detected parameter PF1 (i.e., the detected excursion) generated by the excursion detection device 651 is adaptively fed back to the non-linear compensator 613.

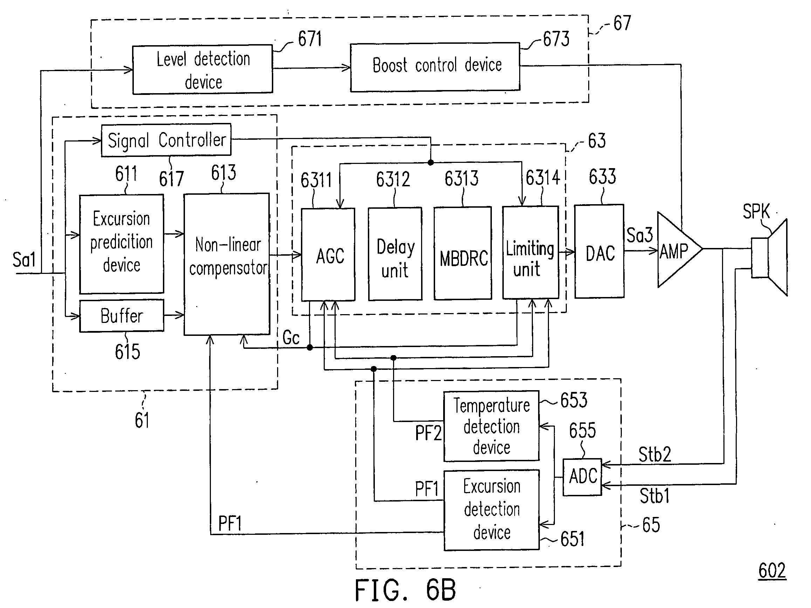

Referring to FIG. 6A and FIG. 6B, wherein, FIG. 6B illustrates a sound producing system 602 according to another embodiment of present application. The sound producing system 602 is obtained by verifying the control apparatus 601 in FIG. 6A. Difference from FIG. 6A, in FIG. 6B, a signal controller 617 is disposed in the compensation unit 61, and an AGC 6311, a delay unit 6312, a MBDRC 6313 and a limiting unit 6314 are disposed in the gain control unit 631.

The operation about the signal controller 617, AGC 6311, a delay unit 6312, a MBDRC 6313 and a limiting unit 6314 can be referred to the embodiment in FIG. 2. It can be realized that, a MBDRC operation may be used in the gain controller device 631, and the quality of the sound broadcasted by the speaker SPK can be promoted.

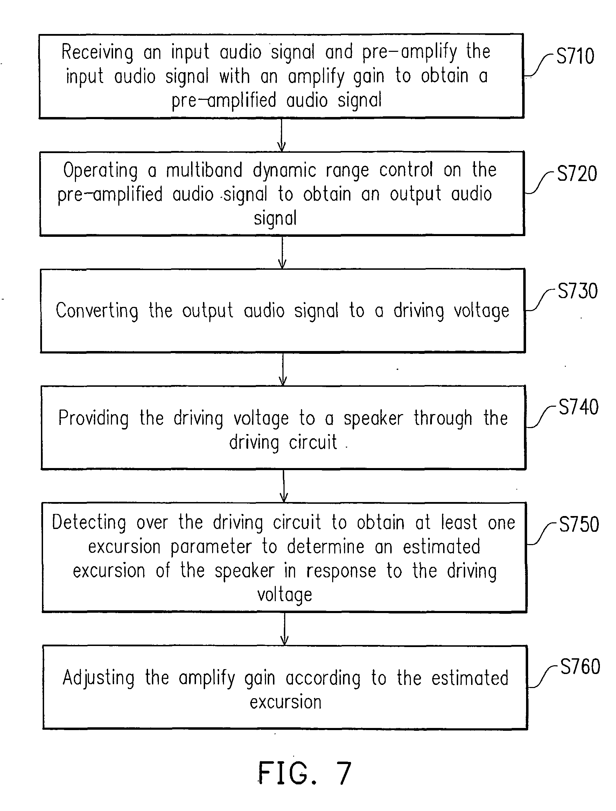

Referring to FIG. 7, FIG. 7 illustrates a flow chart for a sound producing method according to an exemplary embodiment of the present invention. In the step S710, an input audio signal is received and pre-amplified with an amplify gain to obtain a pre-amplified audio signal. In step S720, a multiband dynamic range control is operated on the pre-amplified audio signal to obtain an output audio signal. Moreover, in step S730, the output audio signal is converted to a driving voltage, and the driving voltage is provided to a speaker through the driving circuit in step S740.

In step S750, at least one excursion parameter is detected over the driving circuit to obtain to determine an estimated excursion of the speaker in response to the driving voltage, and the amplify gain may be adjusted according to the estimated excursion in step S760.

Operation details of the audio amplifying method of the present embodiment have been described in detail in the aforementioned embodiment with reference of the sound producing system, so that detailed descriptions thereof are not repeated.

In summary, embodiments of a MDRC integrated current and voltage sensing control method and the corresponding control apparatus are provided. The input audio can be processed according to different frequency bands, and a performance of the output audio form the speaker can be optimized.

It will be apparent to those skilled in the art that various modifications and variations can be made to the structure of the invention without departing from the scope of the invention as defined by the following claims.

## Claims

1. A sound producing system (101) for a portable device, comprising:
a speaker (SPK), for producing an audible sound;
a driving circuit (103), connected to the speaker (SPK);
an audio controller (102), connected to the speaker (SPK) through the driving circuit (103) and configured to:
receive an input audio signal (IN_AU) and pre-amplify the input audio signal (IN_AU) with an amplify gain (UAG) to obtain a pre-amplified audio signal (CIN_AU);
operate a multiband dynamic range control on the pre-amplified audio signal (CIN_AU) to obtain an output audio signal (CP_AU);
convert the output audio signal to a driving voltage;
provide the driving voltage to the speaker (SPK) through the driving circuit (103);
detect across the driving circuit (103) so as to obtain at least one excursion parameter to determine an estimated excursion of the speaker (SPK) in response to the driving voltage; and
adjust the amplify gain (UAG) according to the estimated excursion;
wherein the audio controller (102) is further configured to:
operate the multiband dynamic range control on the pre-amplified audio signal (CIN_AU) to generate a compressed audio signal;
limit an overall level of the compressed audio signal to a threshold level by adding a limiting gain to the compressed audio signal to obtain a limited audio signal as the output audio signal; and
adjust the limiting gain according to estimated excursion of the speaker (SPK);
wherein the speaker (SPK) comprises at least one diaphragm, which has a highest impulse response over a resonance frequency, and the audio controller (102) is further operative to:
operate a first dynamic range control operation over a first frequency band of the pre-amplified audio signal (CIN_AU), wherein the first frequency band is below the resonant frequency;
operate a second dynamic range control operation over a second frequency band of the pre-amplified audio signal (CIN_AU), wherein the second band is higher than the resonant frequency;
wherein the compression ratio of the first dynamic range control operation is higher than the compression ratio of the second dynamic range control operation;
wherein the audio controller (102) is further operative to:
buffer the pre-amplified audio signal (CIN_AU);
filter the buffered pre-amplified audio signal over at least two frequency bands to obtain at least two filtered audio signals each corresponding to one of the at least two frequency bands;
operate separate dynamic range control over the at least two filtered audio signal to obtain at least two compressed filtered audio signals;
sum the at least two compressed filtered audio signals to obtain the compressed audio signals.

2. The sound producing system as claimed in claim 1, wherein the audio controller (102) is further operative to:
feedback a driving current (FC) on the driving circuit (103) in response to the driving voltage (FV) applied on the speaker (SPK) to generate a first excursion parameter;
feedback the output audio signal (CP_AU) to generate a second excursion parameter; and
determine the estimated excursion of the speaker (SPK) in response to the driving voltage based on the first excursion parameter and the second excursion parameter.

3. The sound producing system as claimed in claim 2, wherein the audio controller (102) is configured to calculate an impedance of the speaker (SPK) according to the first and second excursion parameters, and to determine the estimated excursion of the speaker (SPK) according to the impedance.

4. The sound producing system as claimed in claim 1, 2, or 3, wherein the audio controller (102) is further operative to:
delay the input audio signal to obtain a first input audio signal for looking ahead;
determine, based on the first input audio signal, an estimated excursion of the speaker (SPK) in response to the first input audio signal; and
determine whether the first estimated excursion enters a non-linear region of a force factor or stiffness for the speaker (SPK);
compensate the first input audio signal to generate a second input audio signal when the estimated excursion enters the non-linear region;
pre-amplify the second input audio signal with the amplify gain to obtain the pre-amplified audio signal; and
reduce the amplify gain (UAG) when the estimated excursion of the speaker (SPK) exceeds an excursion threshold.

5. The sound producing system as claimed in claim 4, wherein the input audio signal (IN_AU), the pre-amplified audio signal (CIN_AU), and the output audio signal (CP_AU) are digital signals, and the driving circuit (103) comprises:
a digital to analog converter (241) to convert the output audio signal to an analog output signal; and
an amplifier (242) for amplify the analog output audio signal under a bias voltage to obtain the driving voltage;
wherein the audio controller (102) is operative to:
provide the bias voltage to the amplifier;
detect a signal level of the first input audio signal over a time span; and
adjust a level of the bias voltage based on the signal level of the first input audio signal.

6. A sound producing method, comprising:
receiving (S710) an input audio signal and pre-amplify the input audio signal with an amplify gain to obtain a pre-amplified audio signal;
operating (S720) a multiband dynamic range control on the pre-amplified audio signal to obtain an output audio signal;
converting (S730) the output audio signal to a driving voltage;
providing (S740) the driving voltage to a speaker through the driving circuit;
detecting (S750) across the driving circuit so as to obtain at least one excursion parameter to determine an estimated excursion of the speaker in response to the driving voltage; and
adjusting (S760) the amplify gain according to the estimated excursion;
wherein the step of operating (S720) the multiband dynamic range control on the pre-amplified audio signal to obtain the output audio signal comprises:
operating the multiband dynamic range control on the pre-amplified audio signal to generate a compressed audio signal;
limiting an overall level of the compressed audio signal to a threshold level by adding a limiting gain to the compressed audio signal to obtain a limited audio signal as the output audio signal; and
adjusting the limiting gain according to estimated excursion of the speaker;
wherein the speaker (SPK) comprises at least one diaphragm, which has a highest response over a resonance frequency, and wherein preferably the step of operate the multiband dynamic range control on the pre-amplified audio signal comprises:
operating a first dynamic range control operation over a first frequency band of the pre-amplified audio signal, wherein the first frequency band is below the resonant frequency;
operating a second dynamic range control operation over a second frequency band of the pre-amplified audio signal, wherein the second band is higher than the resonant frequency;
wherein the compression ratio of the first dynamic range control operation is higher than the compression ratio of the second dynamic range control operation;
wherein the step of operating (S720) the multiband dynamic range control on the pre-amplified audio signal to obtain the output audio signal further comprises:
buffering the pre-amplified audio signal;
filtering the buffered pre-amplified audio signal over at least two frequency bands to obtain at least two filtered audio signals each corresponding to one of the at least two frequency band;
operating separate dynamic range control over the at least two filtered audio signal to obtain at least two compressed filtered audio signals; and
summing the at least two compressed filtered audio signals to obtain the compressed audio signals.

7. The audio amplifying method as claimed in claim 6, wherein the step of detecting (S750) over the driving circuit to obtain the at least one excursion parameter to determine the estimated excursion of the speaker in response to the driving voltage comprises:
feedback a driving current on the driving circuit in response to the driving voltage applied on the speaker to generate a first excursion parameter
feedback the output audio signal to generate a second excursion parameter; and
determining the estimated excursion of the speaker in response to the driving voltage based on the first excursion parameter and the second excursion parameter.

8. The audio amplifying method as claimed in claim 7, wherein the step of determining the estimated excursion of the speaker in response to the driving voltage based on the first excursion parameter and the second excursion parameter comprises:
calculating an impedance of the speaker by the first and second excursion parameters; and
determining the estimated excursion of the speaker according to the impedance.

9. The audio amplifying method as claimed in claim 6, 7 or 8, further comprising:
delaying the input audio signal to obtain a first input audio signal for looking ahead;
determining, based on the first input audio signal, an estimated excursion distortion of the speaker in response to the first input audio signal; and
determining whether the first estimated excursion entering a non-linear region of a force factor or stiffness for the speaker; and
compensating the first input audio signal to generate a second input audio signal when the estimated excursion enters the non-linear region; and
pre-amplifying the second input audio signal with the amplify gain to obtain a pre-amplified audio signal.

10. The audio amplifying method as claimed in claim 7 or 8, wherein the input audio signal, the pre-amplified audio signal, and the output audio signal are digital signals, and the method further comprises:
converting the output audio signal to an analog output signal;
providing a bias voltage for amplifying the analog output audio signal under the bias voltage to obtain the driving voltage;
detecting a signal level of the first input audio signal over a time span; and
adjusting a level of a bias voltage based on the signal level of the first input audio signal.

## Patentansprüche

1. Tonerzeugungssystem (101) für eine tragbare Vorrichtung, das Folgendes aufweist:
einen Lautsprecher (SPK) zum Erzeugen eines hörbaren Tons;
eine Antriebsschaltung (103), die mit dem Lautsprecher (SPK) verbunden ist;
eine Audiosteuervorrichtung (102), die mit dem Lautsprecher (SPK) durch die Antriebsschaltung (103) verbunden und konfiguriert ist, um:
ein eingegebenes Audiosignal (IN_AU) zu empfangen und das eingegebene Audiosignal (IN_AU) mit einer Verstärkung (UAG) vorzuverstärken, um ein vorverstärktes Audiosignal (CIN_AU) zu erhalten;
eine Mehrbandsteuerung eines dynamischen Bereichs auf dem vorverstärkten Audiosignal (CIN_AU) zu betätigen, um ein ausgegebene Audiosignal (CP_AU) zu erhalten;
das Audioausgabesignal in eine Antriebsspannung umzuwandeln;
die Antriebsspannung an den Lautsprecher (SPK) durch die Antriebsschaltung (103) zu liefern;
über die Antriebsschaltung (103) hinweg zu detektieren, um zumindest einen Abweichungsparameter zu erhalten, um eine geschätzte Abweichung des Lautsprechers (SPK) ansprechend auf die Antriebsspannung zu bestimmen;
und
die Verstärkung (UAG) gemäß der geschätzten Abweichung anzupassen;
wobei die Audiosteuervorrichtung (102) ferner so konfiguriert ist, dass sie:
eine Mehrbandsteuerung eines dynamischen Bereichs auf dem vorverstärkten Audiosignal (CIN_AU) durchführt, um ein komprimiertes Audiosignal zu erzeugen;
einen Gesamtpegel des komprimierten Audiosignals auf einen Schwellenwertpegel begrenzt, und zwar durch Hinzufügen einer Grenzverstärkung zu dem komprimierten Audiosignal, um ein begrenztes Audiosignal als das ausgegebene Audiosignal zu erhalten; und
die Grenzverstärkung gemäß der geschätzten Abweichung des Lautsprechers (SPK) anpasst;
wobei der Lautsprecher (SPK) zumindest eine Membran aufweist, die eine höchste Impulsantwort über einer Resöriänzfrequenz aufweist, und die Audiosteuervorrichtung (102) ferner betreibbar ist, um:
einen ersten dynamischen Bereichssteuervorgang über ein erstes Frequenzband des vorverstärkten Audiosignals (CIN_AU) durchzuführen, wobei das erste Frequenzband unterhalb der Resonanzfrequenz liegt;
einen zweiten dynamischen Bereichssteuervorgang über ein zweites Frequenzband des vorverstärkten Audiosignals (CIN_AU) durchzuführen, wobei das zweite Band höher als die Resonanzfrequenz ist;
wobei das Kompressionsverhältnis des ersten dynamischen Bereichssteuervorgangs höher als das Kompressionsverhältnis des zweiten dynamischen Bereichssteuervorgangs ist;
wobei die Audiosteuervorrichtung (102) ferner betreibbar ist, um:
das vorverstärkte Audiosignal (CIN_AU) zu puffern;
das gepufferte, vorverstärkte Audiosignal über zumindest zwei Frequenzbänder zu filtern, um zumindest zwei gefilterte Audiosignale zu erhalten, die jeweils einem der zumindest zwei Frequenzbänder entsprechen;
die separate, dynamische Bereichssteuerung über die zumindest zwei gefilterten Audiosignale durchzuführen, um zumindest zwei komprimierte Audiosignale zu erhalten;
die zumindest zwei komprimierten, gefilterten Audiosignale aufzusummieren, um die komprimierten Audiosignale zu erhalten.

2. Tonerzeugungssystem gemäß Anspruch 1, wobei die Audiosteuervorrichtung (102) ferner betreibbar ist, um:
einen Antriebsstrom (FC) auf der Antriebsschaltung (103) ansprechend auf die Antriebsspannung (FV), die an den Lautsprecher (SPK) angelegt wird, zurückzuführen bzw. rückzukoppeln, um einen ersten Abweichungsparameter zu erzeugen;
das ausgegebene Audiosignal (CP_AU) rückzukoppeln, um einen zweiten Abweichungsparameter zu erzeugen; und
die geschätzte Abweichung des Lautsprechers (SPK) ansprechend auf die Antriebsspannung basierend auf dem ersten Abweichungsparameter und dem zweiten Abweichungsparameter zu bestimmen.

3. Tonerzeugungssystem gemäß Anspruch 2, wobei die Audiosteuervorrichtung (102) so konfiguriert ist, dass sie eine Impedanz des Lautsprechers (SPK) gemäß den ersten und zweiten Abweichungsparametern berechnet, und dass sie die geschätzte Abweichung des Lautsprechers (SPK) gemäß der Impedanz bestimmt.

4. Tonerzeugungssystem gemäß Anspruch 1, 2 oder 3, wobeidie Audiosteuervorrichtung (102) ferner betreibbar ist, um:
das eingegebene Audiosignal zu verzögern, um ein erstes eingegebenes Audiosignal zur Vorausschau zu erhalten;
basierend auf dem ersten eingegebene Audiosignal eine geschätzte Abweichung des Lautsprechers (SPK) ansprechend auf das erste eingegebene Audiosignal zu bestimmen; und
zu bestimmen, ob die erste geschätzte Abweichung in einen nicht linearen Bereich eines Kraftfaktors oder einer Steifigkeit für den Lautsprecher (SPK) eintritt;
das erste eingegebene Audiosignal zu kompensieren, um ein zweites eingegebenes Audiosignal zu erzeugen, wenn die geschätzte Abweichung in den nicht linearen Bereich eintritt;
das zweite eingegebene Audiosignal mit der Verstärkung zu verstärken, um das vorverstärkte Audiosignal zu erhalten; und
die Verstärkung (UAG) zu verringern, wenn die geschätzte Abweichung des Lautsprechers (SPK) einen Abweichungsschwellenwert übersteigt.

5. Tonerzeugungssystem gemäß Anspruch 4, wobei das eingegebene Audiosignal (IN_AU), das vorverstärkte Audiosignal (CIN_AU) und das ausgegebene Audiosignal (CP_AU) digitale Signale sind, und die Antriebsschaltung (103) Folgendes aufweist:
einen Digital-zu-Analog-Wandler (241) zum Umwandeln des ausgegebenen Audiosignal in ein analoges Ausgabesignal; und
einen Verstärker (242) zum Verstärken des analogen Ausgabesignals unter einer Vorspannung, um die Antriebsspannung zu erhalten;
wobei die Audiosteuervorrichtung (102) betreibbar ist, um:
die Vorspannung an den Verstärker zu liefern;
einen Signalpegel des ersten eingegebenen Audiosignals über eine Zeitspanne hinweg zu detektieren; und
einen Pegel der Vorspannung basierend auf dem Signalpegel des ersten eingegebenen Audiosignals anzupassen.

6. Tonerzeugungsverfahren, das Folgendes aufweist:
Empfangen (S710) eines eingegebenen Audiosignals und Vorverstärken des eingegebenen Audiosignals mit einer Verstärkung, um ein vorverstärktes Audiosignal zu erhalten;
Durchführen (S720) einer Mehrbandsteuerung eines dynamischen Bereichs auf dem vorverstärkten Audiosignal, um ein ausgegebenes Audiosignal zu erhalten;
Umwandeln (S730) des ausgegebenen Audiosignal an eine Antriebsspannung;
Liefern (S740) der Antriebsspannung an einen Lautsprecher durch die Antriebsschaltung;
Detektieren (S750) über die Antriebsschaltung hinweg, um zumindest einen Abweichungsparameter zu erhalten, um eine geschätzte Abweichung des Lautsprechers ansprechend auf die Antriebsspannung zu bestimmen; und
Anpassen (S760) der Verstärkung gemäß der geschätzten Abweichung;
wobei der Schritt des Durchführens (S720) der Mehrbandsteuerung eines dynamischen Bereichs auf dem vorverstärkten Audiosignal zum Erhalten des ausgegebenen Audiosignals Folgendes aufweist:
Durchführen der Mehrbandsteuerung eines dynamischen Bereichs auf dem vorverstärkten Audiosignal, um ein komprimiertes Audiosignal zu erhalten;
Begrenzen eines Gesamtpegels des komprimierten Audiosignals auf einen Schwellenpegel durch Hinzufügen einer Grenzverstärkung zu dem komprimierten Audiosignal, um ein begrenztes Audiosignal als das ausgegebene Audiosignal zu erhalten; und
Anpassen der Grenzverstärkung gemäß der geschätzten Abweichung des Lautsprechers;
wobei der Lautsprecher (SPK) zumindest eine Membran aufweist, die eine höchste Antwort über einer Resonanzfrequenz aufweist, und wobei vorzugsweise der Schritt des Durchführens der Mehrbandsteuerung eines dynamischen Bereichs auf dem vorverstärkten Audiosignal Folgendes aufweist:
Durchführen eines ersten dynamischen Bereichssteuervorgangs über einem ersten Frequenzband des vorverstärkten Audiosignals, wobei das erste Frequenzband unterhalb der Resonanzfrequenz liegt;
Durchführen eines zweiten dynamischen Bereichssteuervorgangs über einem zweiten Frequenzband des vorverstärkten Audiosignals, wobei das zweite Band höher als die Resonanzfrequenz ist;
wobei das Kompressionsverhältnis des ersten dynamischen Bereichssteuervorgangs höher als das Kompressionsverhältnis des zweiten dynamischen Bereichssteuervorgangs ist;
wobei der Schritt des Durchführens (S720) der Mehrbandsteuerung des dynamischen Bereichs auf dem vorverstärkten Audiosignal zum Erhalten des ausgegebenen Audiosignal ferner Folgendes aufweist:
Puffern des vorverstärkten Audiosignals;
Filtern des gepufferten, vorverstärkten Audiosignals über zumindest zwei Frequenzbänder, um zumindest zwei gefilterte Audiosignale zu erhalten, von denen jedes mit einem der zumindest zwei Frequenzbänder übereinstimmt;
Durchführen der separaten dynamischen Bereichssteuerung über die zumindest zwei gefilterten Audiosignale, um zumindest zwei komprimierte, gefilterte Audiosignale zu erhalten; und
Aufsummieren der zumindest zwei komprimierten, gefilterten Audiosignale, um die komprimierten Audiosignale zu erhalten.

7. Audioverstärkungsverfahren gemäß Anspruch 6, wobei der Schritt des Detektierens (S750) über die Antriebsschaltung, um den zumindest einen Abweichungsparameter zu erhalten, um die geschätzte Abweichung des Lautsprechers ansprechend auf die Antriebsspannung zu bestimmen, Folgendes aufweist:
Rückkoppeln eines Antriebsstroms an die Antriebsschaltung ansprechend auf die Antriebsspannung, die an den Lautsprecher angelegt wird, um einen ersten Abweichungsparameter zu erzeugen;
Rückkopppein des ausgegebenen Audiosignals, um einen zweiten Abweichungsparameter zu erzeugen; und
Bestimmen der geschätzten Abweichung des Lautsprechers ansprechend auf die Antriebsspannung basierend auf dem ersten Abweichungsparameter und dem zweiten Abweichungsparameter.

8. Audioverstärkungsverfahren gemäß Anspruch 7, wobei der Schritt der Bestimmung der geschätzten Abweichung des Lautsprechers ansprechend auf die Antriebsspannung basierend auf dem ersten Abweichungsparameter und dem zweiten Abweichungsparameter Folgendes aufweist:
Berechnen einer Impedanz des Lautsprechers durch die ersten und zweiten Abweichungsparameter; und
Bestimmen der geschätzten Abweichung des Lautsprechers gemäß der Impedanz.

9. Audioverstärkungsverfahren gemäß Anspruch 6, 7 oder 8, das ferner Folgendes aufweist:
Verzögern des eingegebenen Audiosignals, um ein erstes eingegebenes Audiosignal für die Vorausschau zu erhalten;
basierend auf dem ersten eingegebene Audiosignal, Bestimmen einer geschätzten Abweichungsverzerrung des Lautsprechers ansprechend auf das erste eingegebene Audiosignal; und
Bestimmen, ob die erste geschätzte Abweichung, in einen nicht linearen Bereich eines Kraftfaktors oder der Steifigkeit des Lautsprechers eintritt; und
Kompensieren des ersten eingegebenen Audiosignals, um ein zweites eingegebenes Audiosignal zu erzeugen, wenn die geschätzte Abweichung in den nicht linearen Bereich eintritt; und
Vorverstärken des zweiten eingegebenen Audiosignals mit der Verstärkung, um ein vorverstärktes Audiosignal zu erhalten.

10. Audioverstärkungsverfahren gemäß Anspruch 7 oder 8, wobei das eingegebene Audiosignal, das vorverstärkte Audiosignal und das ausgegebene Audiosignal digitale Signale sind, und das Verfahren ferner Folgendes aufweist:
Umwandeln des ausgegebenen Audiosignals in ein analoges Ausgabesignal; Liefern einer Vorspannung zur Verstärkung des analogen, ausgegebenen Audiosignals unter der Vorspannung, um die Antriebsspannung zu erhalten;
Detektieren eines Signalpegels des ersten eingegebenen Audiosignals über eine Zeitspanne hinweg; und
Anpassen des Pegels der Vorspannung basierend auf dem Signalpegel des ersten eingegebenen Audiosignals.

## Revendications

1. Système de production de son (101) pour un dispositif portable, comprenant :
un haut-parleur (SPK) pour produire un son audible ;
un circuit de commande (103), connecté au haut-parleur (SPK) ;
un contrôleur audio (102), connecté au haut-parleur (SPK) par l'intermédiaire du circuit de commande (103) et agencé pour :
recevoir un signal audio d'entrée (IN_AU) et pré-amplifier le signal audio d'entrée (IN_AU) avec un gain d'amplification (UAG) pour obtenir un signal audio pré-amplifié (CIN_AU) ;
opérer un contrôle de plage dynamique multi-bande sur le signal audio pré-amplifié (CIN_AU) pour obtenir un signal audio de sortie (CP_AU) ;
convertir le signal audio de sortie en un signal de commande ;
fournir la tension de commande au haut-parleur (SPK) par l'intermédiaire du circuit de commande (103) ;
réaliser une détection aux bornes du circuit de commande (103) de façon à obtenir au moins un paramètre d'excursion pour déterminer une excursion estimée du haut-parleur (SPK) en réponse à la tension de commande ; et
ajusteur le gain d'amplification (UAG) en fonction de l'excursion estimée ;
dans lequel le contrôleur audio (102) est en outre agencé pour :
actionner le contrôle de plage dynamique multi-bande sur le signal audio pré-amplifié (CIN_AU) pour générer un signal audio compressé ;
limiter le niveau global du signal audio compressé à un niveau de seuil en additionnant un gain de limitation au signal audio compressé pour obtenir un signal audio limité comme signal audio de sortie ; et
ajuster le gain de limitation en fonction de l'excursion estimée du haut-parleur (SPK) ;
dans lequel le haut-parleur (SPK) comprend au moins un diaphragme qui a la réponse impulsionnelle la plus élevée pour une fréquence de résonance, et le contrôleur audio (102) est en outre actionnable pour :
opérer une première opération de contrôle de plage dynamique sur une première bande de fréquences du signal audio pré-amplifié (CIN_AU), la première bande de fréquences étant en dessous de la fréquence de résonance ;
opérer une deuxième opération de contrôle de plage dynamique sur une deuxième bande de fréquences du signal audio pré-amplifié (CIN_AU), la deuxième bande étant au-dessus de la fréquence de résonance ;
dans lequel le rapport de compression de la première opération de contrôle de plage dynamique est supérieur au rapport de compression de la deuxième opération de contrôle de plage dynamique ;
dans lequel le contrôleur audio (102) est en outre actionnable pour :
mettre en tampon le signal audio pré-amplifié (CIN_AU) ;
filtrer le signal audio pré-amplifié mis en tampon sur au moins deux bandes de fréquences pour obtenir au moins deux signaux audio filtrés correspondant chacun à l'une desdites au moins deux bandes de fréquences ;
opérer un contrôle de plage dynamique séparé sur lesdits au moins deux signaux audio filtrés pour obtenir au moins deux signaux audio filtrés compressés ;
faire la somme desdits au moins deux signaux audio filtrés compressés pour obtenir les signaux audio compressés.

2. Système de production de son selon la revendication 1, dans lequel le contrôleur audio (102) est en outre actionnable pour :
renvoyer un courant de commande (FC) sur le circuit de commande (103) en réponse à la tension de commande (FV) appliquée sur le haut-parleur (SPK) pour générer un premier paramètre d'excursion ;
renvoyer le signal audio de sortie (CP_AU) pour générer un deuxième paramètre d'excursion ; et
déterminer l'excursion estimée du haut-parleur (SPK) en réponse à la tension de commande sur la base du premier paramètre d'excursion et du deuxième paramètre d'excursion.

3. Système de production de son selon la revendication 2, dans lequel le contrôleur audio (102) est agencé pour calculer une impédance du haut-parleur (SPK) en fonction des premier et deuxième paramètres d'excursion, et pour déterminer l'excursion estimée du haut-parleur (SPK) en fonction de l'impédance.

4. Système de production de son selon la revendication 1, 2 ou 3, dans lequel le contrôleur audio (102) est en outre actionnable pour :
retarder le signal audio d'entrée pour obtenir un premier signal audio d'entrée pour regarder en avant ;
déterminer, sur la base du premier signal audio d'entrée, une excursion estimée du haut-parleur (SPK) en réponse au premier signal audio d'entrée ; et
déterminer si la première excursion estimée pénètre dans une région non linéaire d'un facteur de force ou de rigidité pour le haut-parleur (SPK) ;
compenser le premier signal audio d'entrée pour générer un deuxième signal audio d'entrée lorsque l'excursion estimée pénètre dans la région non linéaire ;
pré-amplifier le deuxième signal audio d'entrée avec le gain d'amplification pour obtenir le signal audio préamplifié ; et
réduire le gain d'amplification (UAG) lorsque l'excursion estimée du haut-parleur (SPK) dépasse un seuil d'excursion.

5. Système de production de son selon la revendication 4, dans lequel le signal audio d'entrée (IN_AU), le signal audio pré-amplifié (CIN_AU), et le signal audio de sortie (CP_AU) sont des signaux numériques, et le circuit de commande (103) comprend :
un convertisseur numérique-analogique (241) pour convertir le signal audio de sortie en un signal de sortie analogique ; et
un amplificateur (242) pour amplifier le signal audio de sortie analogique sous une tension de polarisation pour obtenir la tension de commande ;
dans lequel le contrôleur audio (102) est actionnable pour :
fournir la tension de polarisation à l'amplificateur ;
détecter le niveau de signal du premier signal audio d'entrée sur un intervalle de temps ; et
ajuster le niveau de la tension de polarisation sur la base du niveau de signal du premier signal audio d'entrée.

6. Procédé de production de son, comprenant :
recevoir (S710) un signal audio d'entrée et pré-amplifier le signal audio d'entrée avec un gain d'amplification pour obtenir un signal audio pré-amplifié ;
actionner (S720) un contrôle de plage dynamique multi-bande sur le signal audio pré-amplifié pour obtenir un signal audio de sortie ;
convertir (S730) le signal audio de sortie en une tension de commande ;
fournir (S740) la tension de commande à un haut-parleur par l'intermédiaire du circuit de commande ;
réaliser une détection (S750) aux bornes du circuit de commande de façon à obtenir au moins un paramètre d'excursion pour déterminer une excursion estimée du haut-parleur en réponse à la tension de commande ; et
ajuster (S760) le gain d'amplification en fonction de l'excursion estimée ;
dans lequel l'étape consistant à actionner (S720) le contrôle de plage dynamique multi-bande sur le signal audio,pré-amplifié pour obtenir le signal audio de sortie comprend :
actionner le contrôle de plage dynamique multi-bande sur le signal audio pré-amplifié pour générer un signal audio compressé ;
limiter le niveau global du signal audio compressé à un niveau de seuil en additionnant un gain de limitation au signal audio compressé pour obtenir un signal audio limité comme signal audio de sortie ; et
ajuster le gain de limitation en fonction de l'excursion estimée du haut-parleur ;
dans lequel le haut-parleur (SPK) comprend au moins un diaphragme qui a la réponse la plus élevée pour une fréquence de résonance, et dans lequel de préférence, l'étape consistant à actionner le contrôle de plage dynamique multi-bande sur le signal audio pré-amplifié comprend :
opérer une première opération de contrôle de plage dynamique sur une première bande de fréquences du signal audio pré-amplifié, la première bande de fréquences étant en dessous de la fréquence de résonance ;
opérer une deuxième opération de contrôle de plage dynamique sur une deuxième bande de fréquences du signal audio pré-amplifié, la deuxième bande étant au-dessus de la fréquence de résonance ;
dans lequel le rapport de compression de la première opération de contrôle de plage dynamique est supérieur au rapport de compression de la deuxième opération de contrôle de plage dynamique ;
dans lequel l'étape consistant à actionner (S720) le contrôle de plage dynamique multi-bande sur le signal audio pré-amplifié pour obtenir un signal audio de sortie comprend :
mettre en tampon le signal audio pré-amplifié ;
filtrer le signal audio pré-amplifié mis en tampon sur au moins deux bandes de fréquences pour obtenir au moins deux signaux audio filtrés correspondant chacun à l'une desdites au moins deux bandes de fréquences ;
opérer un contrôle de plage dynamique séparé sur lesdits au moins deux signaux audio filtrés pour obtenir au moins deux signaux audio filtrés compressés ;
faire la somme desdits au moins deux signaux audio filtrés compressés pour obtenir les signaux audio compressés.

7. Procédé d'amplification audio selon la revendication 6, dans lequel l'étape consistant à réaliser une détection (S750) sur le circuit de commande pour obtenir ledit au moins un paramètre d'excursion pour déterminer l'excursion estimée du haut-parleur en fonction de la tension de commande comprend :
renvoyer un courant de commande sur le circuit de commande en réponse à la tension de commande appliquée sur le haut-parleur pour générer un premier paramètre d'excursion ;
renvoyer le signal audio de sortie pour générer un deuxième paramètre d'excursion ; et
déterminer l'excursion estimée du haut-parleur en réponse à la tension de commande sur la base du premier paramètre d'excursion et du deuxième paramètre d'excursion.

8. Procédé d'amplification audio selon la revendication 7, dans lequel l'étape consistant à déterminer l'excursion estimée du haut-parleur en fonction de la tension de commande sur la base du premier paramètre d'excursion et du deuxième paramètre d'excursion comprend :
calculer une impédance du haut-parleur par les premier et deuxième paramètres d'excursion ; et
déterminer l'excursion estimée du haut-parleur en fonction de l'impédance.

9. Procédé d'amplification audio selon la revendication 6, 7 ou 8, comprenant en outre :
retarder le signal audio d'entrée pour obtenir un premier signal audio d'entrée pour regarder en avant ;
déterminer, sur la base du premier signal audio d'entrée, une excursion estimée du haut-parleur en réponse au premier signal audio d'entrée ; et
déterminer si la première excursion estimée pénètre dans une région non linéaire d'un facteur de force ou de rigidité pour le haut-parleur ; et
compenser le premier signal audio d'entrée pour générer un deuxième signal audio d'entrée lorsque l'excursion estimée pénètre dans la région non linéaire ; et
pré-amplifier le deuxième signal audio d'entrée avec le gain d'amplification pour obtenir le signal audio pré-amplifié.

10. Procédé d'amplification audio selon la revendication 7 ou 8, dans lequel le signal audio d'entrée, le signal audio pré-amplifié, et le signal audio de sortie sont des signaux numériques, et le procédé comprend en outre :
convertir le signal audio de sortie en un signal de sortie analogique ;
fournir une tension de polarisation pour amplifier le signal audio de sortie analogique sous la tension de polarisation pour obtenir la tension de commande ;
détecter le niveau de signal du premier signal audio d'entrée sur un intervalle de temps ; et
ajuster le niveau d'une tension de polarisation sur la base du niveau de signal du premier signal audio d'entrée.
